# EUROPÄISCHE PATENTSCHRIFT

(11) **EP 4 500 579 B1**
(45) Veröffentlichungstag und Bekanntmachung des Hinweises auf die Patenterteilung: **12.11.2025**
(21) Anmeldenummer: 23726903.0
(22) Anmeldetag: 10.05.2023
(51) Int. Cl.: H01L 21/60, H01L 23/485

(54) **VERFAHREN ZUR HERSTELLUNG EINER HALBLEITERANORDNUNG MIT EINEM HALBLEITERELEMENT UND EINEM SUBSTRAT, SOWIE ZUGEHÖRIGE HALBLEITERANORDNUNG**
METHOD OF MANUFACTURING A SEMICONDUCTOR ASSEMBLY COMPRISING A SEMICONDUCTOR ELEMENT AND A SUBSTRATE AND CORRESPONDING SEMICONDUCTOR ASSEMBLY
PROCÉDÉ DE FABRICATION D'UN ENSEMBLE SEMI-CONDUCTEUR DOTÉ D'UN ÉLÉMENT SEMI-CONDUCTEUR ET D'UN SUBSTRAT ET ENSEMBLE SEMI-CONDUCTUER CORRESPONDANT

(30) Priorität: 29.06.2022 EP 22181763
(43) Veröffentlichungstag der Anmeldung: 05.02.2025
(73) Patentinhaber: Siemens Aktiengesellschaft, 80333 München (DE)
(72) Erfinder: SCHMENGER, Jens, 91301 Forchheim (DE)
(74) Vertreter: Siemens Patent Attorneys
(86) Internationale Anmeldenummer: PCT/EP2023/062359
(87) Internationale Veröffentlichungsnummer: WO 2024/002572

(56) Entgegenhaltungen:
- WO-A1-2021/151949
- DE-B3- 102017 107 117
- JP-A- 2007 109 880
- US-A1- 2015 371 937

## Beschreibung

Die Erfindung betrifft ein Verfahren zur Herstellung einer Halbleiteranordnung mit einem Halbleiterelement und einem Substrat.

Ferner betrifft die Erfindung eine Halbleiteranordnung mit einem Halbleiterelement und einem Substrat.

Darüber hinaus betrifft die Erfindung einen Stromrichter mit mindestens einer derartigen Halbleiteranordnung.

Eine derartige Halbleitermodulanordnung kommt in der Regel in einem Stromrichter zum Einsatz. Unter einem Stromrichter ist beispielsweise ein Gleichrichter, ein Wechselrichter, ein Umrichter oder ein Gleichspannungswandler zu verstehen. Die in der Halbleitermodulanordnung zum Einsatz kommenden Halbleiterelemente sind unter anderem Transistoren, Dioden, Triacs oder Thyristoren. Die Transistoren sind beispielsweise als Insulated-Gate-Bipolar-Transistoren (IGBTs), Feldeffekttransistoren oder Bipolartransistoren ausgeführt. Derartige Transistoren können einen Steuerkontakt und Lastkontakte umfassen. Üblicherweise werden Halbleiterelemente über Bonddrähte, welche insbesondere Aluminium enthalten, kontaktiert.

Die Offenlegungsschrift EP 3 958 306 A1 beschreibt ein Leistungsmodul mit mindestens zwei auf einem Substrat kontaktierten Leistungshalbleiteranordnungen, welche in einem Gehäuse angeordnet sind. Um die Zuverlässigkeit des Leistungsmoduls zu verbessern, wird vorgeschlagen, dass die Leistungshalbleiteranordnungen jeweils mindestens ein Halbleiterbauelement aufweisen, wobei das Gehäuse auf gegenüberliegenden Seiten Leistungsanschlüsse aufweist, wobei das Substrat Zuleitungen von den Leistungsanschlüssen zu den Leistungshalbleiteranordnungen aufweist, wobei die Zuleitungen derartig auf dem Substrat angeordnet sind, dass eine symmetrische Stromführung erfolgt.

Die Offenlegungsschrift WO 2022/002464 A1 beschreibt ein Leistungsmodul mit mindestens zwei Leistungseinheiten, welche jeweils mindestens einen Leistungshalbleiter und ein Substrat umfassen. Um den erforderlichen Bauraum des Leistungsmoduls zu verringern und eine Entwärmung zu verbessern, wird vorgeschlagen, dass der jeweils mindestens eine Leistungshalbleiter, insbesondere stoffschlüssig, mit dem jeweiligen Substrat verbunden ist, wobei die Substrate der mindestens zwei Leistungseinheiten jeweils unmittelbar stoffschlüssig mit einer Oberfläche eines gemeinsamen Kühlkörpers verbunden sind.

Die Patentschrift DE 20 2012 004 434 U1 beschreibt einen Metallformkörper zur Schaffung einer Verbindung eines Leistungshalbleiters mit oberseitigen Potentialflächen zu Dickdrähten oder Bändchen, wobei durch einen Metallformkörper, der eine oder mehrere Potentialflächen überragt und aus dem elektrisch vom übrigen Metallformkörper getrennt wenigstens ein Segment abgeteilt ist, das von einem Kontaktierungsabschnitt an eine Potentialfläche des Leistungshalbleiters zu einem davon lateral beabstandeten Befestigungsabschnitt für Dickdrähte reicht.

Die Offenlegungsschrift JP 2007 109 880 A offenbart ein Verfahren zur Herstellung einer Halbleiteranordnung, wobei ein Leistungskontakt über einen Metallformkörper in Form eines Wärmeverteilers stoffschlüssig mit einem Kontaktierungselement verbunden wird.

Die Patentschrift DE 10 2017 107 117 B3 offenbart ein Verfahren zur Herstellung einer Halbleiteranordnung, wobei ein metallisches Kontaktierungselement über ein dielektrisches Druckelement an ein Halbleiterelement angepresst wird.

Insbesondere für bei konstanter Chipfläche immer größeren in den Chip eingeprägten Strömen kommen üblicherweise verwendete Bonddrähte, beispielsweise hinsichtlich der Lastwechselfestigkeit, an ihre Grenzen.

Vor diesem Hintergrund ist es eine Aufgabe der vorliegenden Erfindung, eine Halbleiteranordnung anzugeben, welche eine verbesserte Zuverlässigkeit aufweist.

Diese Aufgabe wird erfindungsgemäß gelöst durch ein Verfahren zur Herstellung einer Halbleiteranordnung mit einem Halbleiterelement und einem Substrat umfassend folgende Schritte: Stoffschlüssiges Verbinden eines ersten Leistungskontakts des Halbleiterelements mit einer ersten Metallisierung des Substrats und eines zweiten Leistungskontakts des Halbleiterelements, welcher auf einer dem Substrat abgewandten Seite des Halbleiterelements angeordnet ist, mit einem Metallformkörper, Kontaktieren eines metallischen Kontaktierungselements über den Metallformkörper mit dem zweiten Leistungskontakt, Anpressen des metallischen Kontaktierungselements über ein dielektrisches Druckelement an das Halbleiterelement, wobei über das dielektrische Druckelement eine senkrecht auf das Halbleiterelement wirkende Kraft übertragen wird, wobei das metallische Kontaktierungselement unmittelbar flächig auf dem Metallformkörper kontaktiert wird.

Ferner wird die Aufgabe erfindungsgemäß gelöst durch eine Halbleiteranordnung mit einem Halbleiterelement und einem Substrat, wobei das Halbleiterelement einen ersten Leistungskontakt und einen zweiten Leistungskontakt aufweist, wobei der erste Leistungskontakt stoffschlüssig mit einer ersten Metallisierung des Substrats verbunden ist, wobei der zweite Leistungskontakt auf einer dem Substrat abgewandten Seite des Halbleiterelements stoffschlüssig mit einem Metallformkörper verbunden ist, wobei ein metallisches Kontaktierungselement über den Metallformkörper mit dem zweiten Leistungskontakt kontaktiert ist, wobei das metallische Kontaktierungselement über ein dielektrisches Druckelement an das Halbleiterelement angepresst ist, wobei über das dielektrische Druckelement eine senkrecht auf das Halbleiterelement wirkende Kraft übertragen wird, wobei das metallische Kontaktierungselement unmittelbar flächig auf dem Metallformkörper kontaktiert ist.

Darüber hinaus wird die Aufgabe erfindungsgemäß gelöst durch einen Stromrichter mit mindestens einer derartigen Halbleiteranordnung.

Die in Bezug auf die Halbleiteranordnung nachstehend angeführten Vorteile und bevorzugten Ausgestaltungen lassen sich sinngemäß auf den Stromrichter und das Verfahren übertragen.

Der Erfindung liegt die Überlegung zugrunde, die Lastwechselfestigkeit einer Halbleiteranordnung durch eine verbesserte Kontaktierung von Halbleiterelementen zu verbessern. Ein erster Lastkontakt des Halbleiterelements wird stoffschlüssig mit einer ersten Metallisierung eines Substrats verbunden. Die erste Metallisierung des Substrats kann strukturiert ausgeführt und auf einer dielektrische Materiallage, welche unter anderem einen keramischen Werkstoff wie Aluminiumnitrid oder Aluminiumoxid oder einen organischen Werkstoff enthalten kann, angeordnet sein. Beispielsweise ist die erste Metallisierung als eine Kupferkaschierung ausgeführt. Auf einer dem Substrat abgewandten Seite des Halbleiterelements wird ein Metallformkörper stoffschlüssig mit einem zweiten Lastkontakt des Halbleiterelements verbunden. Der Metallformkörper kann, unter anderem als Blech, insbesondere als ein Kupferblech, ausgeführt sein. Die stoffschlüssige Verbindung des Halbleiterelements zur ersten Metallisierung und zum Metallformkörper kann jeweils, unter anderem, durch Löten, Sintern, aber auch durch eine adhäsive Verbindung, **z.B.** mit einem elektrisch und thermisch leitfähigen Kleber, hergestellt werden. Alternativ kann der Metallformkörper mittels eines additiven Verfahrens, insbesondere mittels eines thermischen Spritzverfahrens wie Kaltgasspritzen, auf dem zweiten Lastkontakt des Halbleiterelements aufgebracht und auf diese Weise stoffschlüssig mit dem zweiten Lastkontakt des Halbleiterelements verbunden sein.

In einem weiteren Schritt wird ein metallisches Kontaktierungselement über den Metallformkörper mit dem zweiten Lastkontakt kontaktiert. Das metallische Kontaktierungselement kann unter anderem als dünnes Metallblech oder Metallplättchen ausgeführt sein, welches beispielsweise aus Kupfer, Aluminium, Silber, Gold oder einer deren Legierungen hergestellt sein kann und eine große Kontaktfläche mit dem Metallformkörper ermöglicht. Das metallische Kontaktierungselement kann insbesondere konfiguriert sein, um mit der ersten Metallisierung des Substrats kontaktiert oder an einen externen Anschluss geführt zu werden.

Daraufhin wird das des metallische Kontaktierungselements über ein dielektrisches Druckelement auf den Metallformkörper und somit an das Halbleiterelement gepresst. Das dielektrische Druckelement kann beispielsweise ein dielektrisches Elastomer enthalten. Das Anpressen erfolgt indem über das dielektrische Druckelement eine senkrecht auf den zweiten Lastkontakt des Halbleiterelements wirkende Kraft übertragen wird. Insbesondere weist das dielektrische Druckelement zumindest eine ebene Oberfläche auf, welche flächig auf das metallische Kontaktierungselement aufgelegt wird, wobei das dielektrische Druckelement daraufhin zum Anpressen des dielektrischen Druckelements auf den Metallformkörper mit der Kraft beaufschlagt wird. Auf diese Weise wird eine vergleichswese großflächige Kontaktierung durch das metallische Kontaktierungselement erreicht, was zu einer hohen Stromtragfähigkeit führt und insbesondere die Lastwechselfestigkeit der Halbleiteranordnung verbessert. Somit wird eine verbesserte Zuverlässigkeit der Halbleiteranordnung, beispielsweise beim Einbau in einem Stromrichter, erreicht. Überdies bleibt, insbesondere im Vergleich zu einem Standard-Bondverfahren, eine Architektur der Halbleiteranordnung weitestgehend erhalten. Darüber hinaus ist ein derartiges Herstellungsverfahren einfach und kostengünstig in einen Standard-Serienherstellungsprozess integrierbar.

Das metallische Kontaktierungselement wird unmittelbar flächig auf dem Metallformkörper kontaktiert. Eine unmittelbare Kontaktierung erfolgt ohne weitere Verbindungsmittel wie Lötzinn oder Kleber. Eine derartige Kontaktierung ist, insbesondere in Kombination mit dem Anpressen, einfach und zuverlässig.

Eine weitere Ausführungsform sieht vor, dass nach dem Anpressen ein Vergießen der Halbleiteranordnung erfolgt. Durch eine Vergussmasse, welcher z.B. Silikon enthält, werden erforderliche Spannungsabstände eingehalten. Ferner dient ein derartiger Verguss zum Schutz vor schädlichen Umwelteinflüssen.

Eine weitere Ausführungsform sieht vor, dass das dielektrische Druckelement beim Anpressen vorwiegend elastisch verformt wird. Beispielsweise enthält das dielektrische Druckelement ein dielektrisches Elastomer wie PUR, PVC oder Silikon. Durch eine vorwiegend elastische Verformung wird ein ausreichender Anpressdruck auch bei Lastwechseln und Temperaturschwankungen gewährleistet, sodass eine verbesserte Zuverlässigkeit erreicht wird. Ferner können Höhenunterschiede zwischen Halbleiterelement und Substrat sowie ggf. ein Verkippen des Halbleiterelements ausgeglichen werden, was sich ebenfalls positiv auf die Zuverlässigkeit der Halbleiteranordnung auswirkt.

Eine weitere Ausführungsform sieht vor, dass das dielektrische Druckelement über einen Gehäusedeckel angepresst wird. Der in den meisten Fällen bereits vorhandene Gehäusedeckel ist insbesondere aus einem dielektrischen Werkstoff, z.B. aus einem Kunststoff, hergestellt und kann einfach und kostengünstig, beispielsweise mittels Schrauben oder Adhäsion, dauerhaft an einem Gehäuserahmen befestigt werden.

Eine weitere Ausführungsform sieht vor, dass das metallische Kontaktierungselement zur Verbindung des zweiten Leistungskontakts stoffschlüssig mit der ersten Metallisierung des Substrats verbunden wird. Die stoffschlüssige Verbindung kann, unter anderem, durch Löten, Sintern, aber auch durch Adhäsion, z.B. mit einem elektrisch und thermisch leitfähigen Kleber, hergestellt werden. Eine derartige Anordnung ist einfach und kostengünstig realisierbar.

Eine weitere Ausführungsform sieht vor, dass das metallische Kontaktierungselement zur Verbindung des zweiten Leistungskontakts über das dielektrische Druckelement auf die erste Metallisierung des Substrats gepresst wird. Durch eine derartige Verbindung wird, insbesondere bei häufigen Lastwechseln und Temperaturschwankungen, eine verbesserte Zuverlässigkeit erreicht.

Im Folgenden wird die Erfindung anhand der in den Figuren dargestellten Ausführungsbeispiele näher beschrieben und erläutert.

Es zeigen:
- FIG 1: eine schematische Querschnittsdarstellung einer ersten Ausführungsform einer Halbleiteranordnung,
- FIG 2: ein Ablaufdiagramm eines Verfahrens zur Herstellung einer Halbleiteranordnung,
- FIG 3: eine schematische Querschnittsdarstellung einer zweiten Ausführungsform einer Halbleiteranordnung,
- FIG 4: einen perspektivisch dargestellten schematischen Ausschnitt einer dritten Ausführungsform einer Halbleiteranordnung,
- FIG 5: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

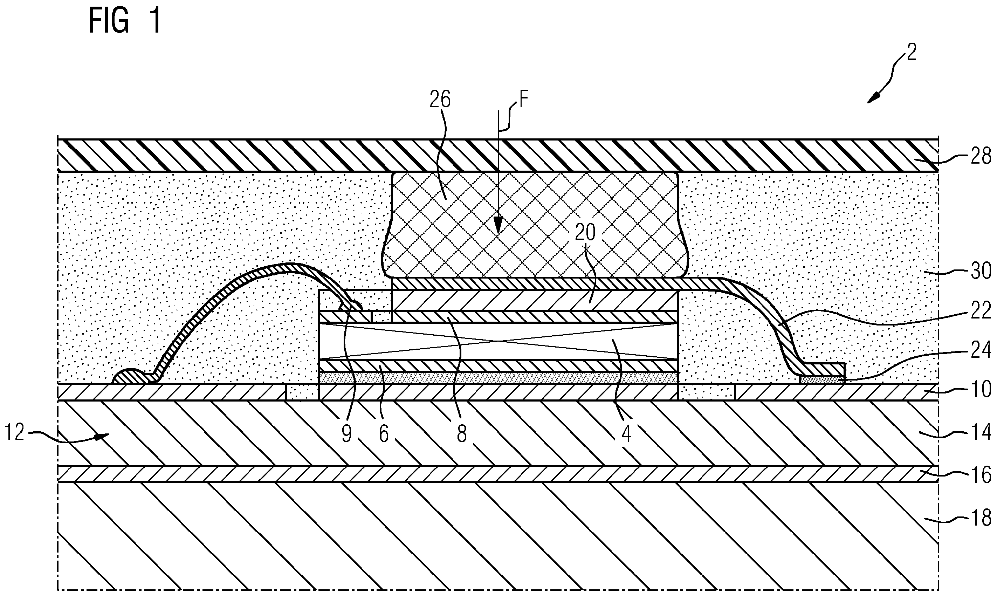

FIG 1 zeigt eine schematische Querschnittsdarstellung einer ersten Ausführungsform einer Halbleiteranordnung 2, welche ein Halbleiterelement 4 umfasst, das als vertikaler Leistungstransistor, insbesondere als Insulated-Gate-BipolarTransistor (IGBT), ausgeführt ist. Weitere Beispiele für derartige Halbleiterelemente 4 sind Triacs, Thyristoren, Dioden oder andere Transistortypen wie Feldeffekttransistoren und Bipolartransistoren. Das Halbleiterelement 4 weist einen ersten Lastkontakt 6, einen zweiten Lastkontakt 8 und einen Steuerkontakt 9 auf.

Der erste Lastkontakt 6 des Halbleiterelements 4 ist stoffschlüssig mit einer strukturierten ersten Metallisierung 10 eines Substrats 12 verbunden. Die stoffschlüssige Verbindung des Halbleiterelements 4 mit dem Substrat 12 kann unter anderem durch eine Lötverbindung und/oder eine Sinterverbindung, aber auch durch eine adhäsive Verbindung, z.B. mit einem elektrisch und thermisch leitfähigen Kleber, hergestellt sein. Das Substrat 12 weist darüber hinaus eine dielektrische Materiallage 14 und eine auf einer der ersten Metallisierung 10 abgewandten Seite des Substrats 12 angeordnete zweite Metallisierung 16 auf. Die dielektrische Materiallage 14 kann unter anderem einen keramischen Werkstoff, insbesondere Aluminiumnitrid oder Aluminiumoxid, oder einen organischen Werkstoff enthalten. Ferner ist das Substrat 12 über die zweite Metallisierung 16, insbesondere stoffschlüssig, mit einem Kühlkörper 18 verbunden, sodass das Halbleiterelement 4 über das Substrat mit dem Kühlkörper 18 in einer elektrisch isolierenden und thermisch leitfähigen Verbindung steht.

Der zweite Lastkontakt 8 des Halbleiterelements 4, welcher auf einer dem Substrat 12 abgewandten Seite des Halbleiterelements 4 angeordnet ist, ist stoffschlüssig mit einem Metallformkörper 20 verbunden, welcher als eine Bufferschicht fungiert. Beispielsweise ist der Metallformkörper 20 als ein Blech, welches unter anderem Kupfer, Aluminium, Silber, Gold, Molybdän oder eine deren Legierungen enthalten kann, ausgeführt, welches über eine Sinterverbindung mit der Steuerkontakt-Kontaktfläche verbunden ist. Ferner kann das Blech eine einseitige oder beidseitige Beschichtung, beispielsweise zur Herstellung einer Bondverbindung, aufweisen. Eine derartige Beschichtung kann unter anderem Aluminium, Silber, Gold, Zink oder eine deren Legierungen enthalten. Alternativ kann der Metallformkörper 20 mittels eines additiven Verfahrens, insbesondere mittels eines thermischen Spritzverfahrens wie Kaltgasspritzen, aufgebracht sein.

Ferner ist ein metallisches Kontaktierungselement 22 über den Metallformkörper 20 mit dem zweiten Lastkontakt 8 des Halbleiterelements 4 elektrisch leitend verbunden, wobei das metallische Kontaktierungselement 22 unmittelbar, das heißt ohne weitere Verbindungsmittel, und flächig auf dem Metallformkörper 20 kontaktiert wird. Das metallische Kontaktierungselement 22 ist im Bereich der Kontaktierung mit dem Metallformkörper 20 im Wesentlichen eben ausgeführt. Darüber hinaus ist das metallische Kontaktierungselement 22 beispielhaft einseitig an der ersten Metallisierung 10 des Substrats 12 über eine stoffschlüssige Verbindung 24 befestigt. Die stoffschlüssige Verbindung 24 kann unter anderem über Sintern, Löten oder ein Schweißverfahren hergestellt werden. Insbesondere ist das metallische Kontaktierungselement 22 aus Kupfer, Aluminium, Silber, Gold oder einer anderen Legierung hergestellt.

Über ein dielektrisches Druckelement 26, welches beispielsweise ein dielektrisches Elastomer enthält, wird das metallische Kontaktierungselements 22 auf den mit dem Halbleiterelement 4 verbundenen Metallformkörper 20 gepresst, wobei über das dielektrische Druckelement 26 eine senkrecht auf das Halbleiterelement 4 wirkende Kraft F übertragen wird. Das dielektrische Druckelement 26 wird beim Anpressen des metallischen Kontaktierungselements 22 auf dem Metallformkörper 20 vorwiegend elastisch verformt. Überdies wird das dielektrische Druckelement 26 in FIG 1 über einen Gehäusedeckel 28, welcher aus einem dielektrischen Werkstoff hergestellt ist, der eine geringere Elastizität aufweist als das dielektrische Druckelement 26, an das Halbleiterelement 4 angepresst. Der Gehäusedeckel 28 wird, beispielsweise mittels Schrauben oder Adhäsion, an einem Gehäuserahmen befestigt, der aus Gründen der Übersichtlichkeit in FIG 1 nicht dargestellt ist. Der Gehäusedeckel 28 und das dielektrische Druckelement 26 können einteilig ausgeführt sein. Darüber hinaus ist die Halbleiteranordnung 2 zwischen Gehäusedeckel 28 und Substrat 12 mittels einer Vergussmasse 30, welcher z.B. Silikon enthält und zur Einhaltung der erforderlichen Spannungsabstände und zum Schutz vor schädlichen Umwelteinflüssen dient, vergossen.

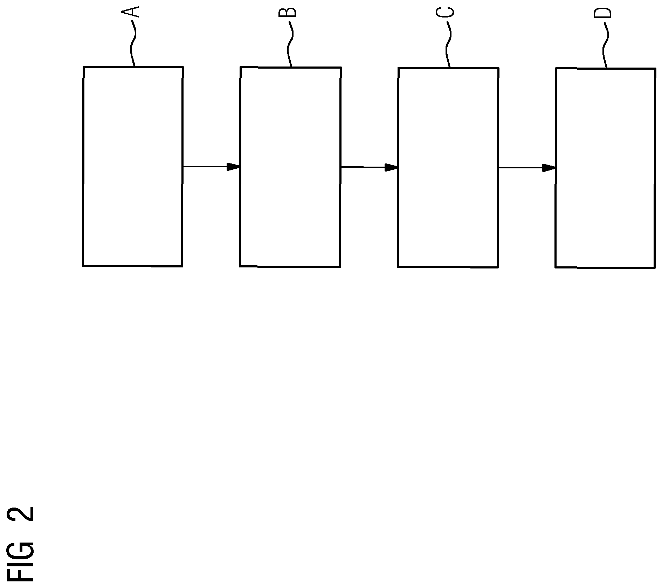

FIG 2 zeigt ein Ablaufdiagramm eines Verfahrens zur Herstellung einer Halbleiteranordnung 2, welche beispielsweise wie in FIG 1 dargestellt ausgeführt ist. Das Verfahren umfasst ein stoffschlüssiges Verbinden A eines ersten Lastkontakts 6 des Halbleiterelements 4 mit einer ersten Metallisierung 10 des Substrats 12 und eines zweiten Lastkontakts 8 des Halbleiterelements 4, welcher auf einer dem Substrat 12 abgewandten Seite des Halbleiterelements 4 angeordnet ist, mit einem Metallformkörper 20.

In einem weiteren Schritt erfolgt ein Kontaktieren B eines metallischen Kontaktierungselements 22 über den Metallformkörper 20 mit dem zweiten Lastkontakt 8. Das Kontaktieren B des profilierten Kontaktierungselements 22 erfolgt unmittelbar und flächig auf dem Metallformkörper 20.

Ein Anpressen C des metallischen Kontaktierungselements 22 an das Halbleiterelement 4 über ein dielektrisches Druckelement 26 erfolgt in einem weiteren Schritt, wobei das dielektrische Druckelement 26 beim Anpressen C vorwiegend elastisch verformt und über das dielektrische Druckelement 26 eine senkrecht auf das Halbleiterelement 4 wirkende Kraft F übertragen wird. Nach dem Anpressen C erfolgt ein Vergießen D der Halbleiteranordnung 4 mittels einer Vergussmasse 30.

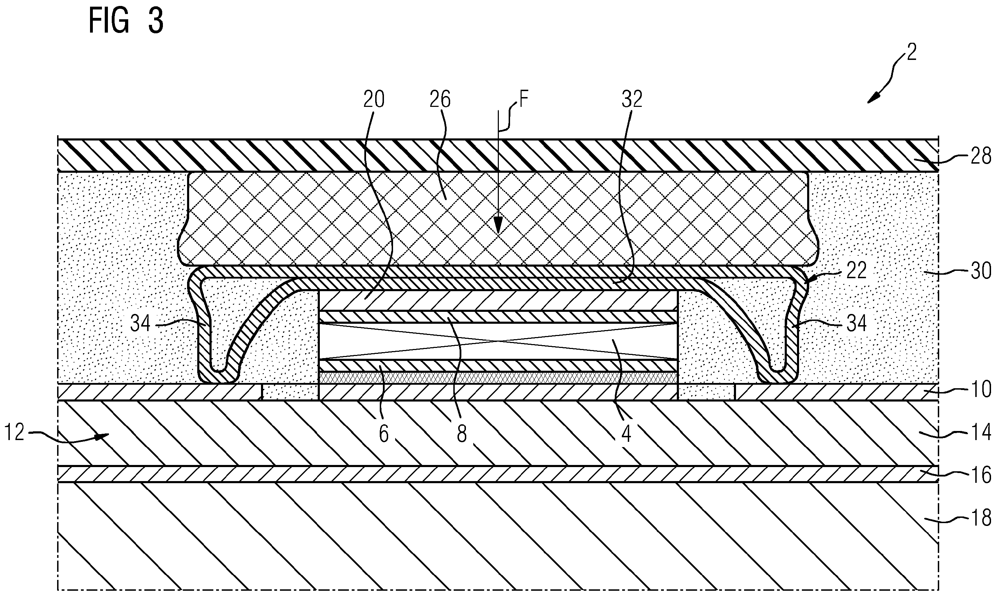

FIG 3 zeigt eine schematische Querschnittsdarstellung einer zweiten Ausführungsform einer Halbleiteranordnung 2. Das metallische Kontaktierungselement 22 ist als ein im Querschnitt geschlossen ausgeführtes Federblech ausgeführt, welches im Bereich der Kontaktierung mit dem Metallformkörper 20 einen ebenen Abschnitt 32 und elastische Abschnitte 34 aufweist.

Der ebene Abschnitt 32 wird über das dielektrisches Druckelement 26 unmittelbar und flächig auf den Metallformkörper 20 gepresst. Ferner werden die elastischen Abschnitte 34 des metallischen Kontaktierungselements 22 beidseitig auf die erste Metallisierung 10 des Substrats 12 gepresst, wobei sich sowohl die elastischen Abschnitte 34 als auch das dielektrisches Druckelement 26 vorwiegend elastisch verformen. Auf diese Weise wird der zweite Lastkontakt 8 des Halbleiterelements 4 ohne eine stoffschlüssige Verbindung und ohne Verbindungsmittel wie Lötzinn, Sinterpaste oder Klebstoff mit der ersten Metallisierung 10 des Substrats 12, insbesondere durch Kraftschluss, verbunden. Die weitere Ausführung der Halbleiteranordnung 2 in FIG 3 entspricht der in FIG 1.

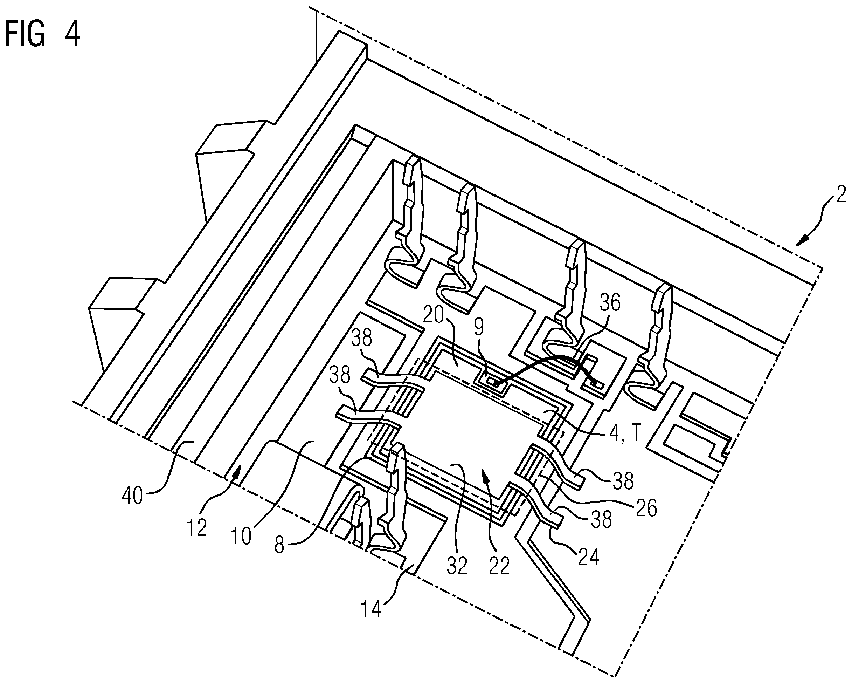

FIG 4 zeigt einen perspektivisch dargestellten schematischen Ausschnitt einer dritten Ausführungsform einer Halbleiteranordnung 2, welche ein Halbleiterelement 4 umfasst, das als Transistor T ausgeführt ist. Der Transistor T ist exemplarisch als IGBT ausgeführt, dessen Steuerkontakt 9 über einen Bonddraht 36 mit der ersten Metallisierung 10 des Substrats 12 verbunden ist. Das metallische Kontaktierungselement 22 ist als Leadframe ausgeführt, welcher beispielhaft vier zweiseitig angeordnete Zuleitungen 38 umfasst, welche über eine stoffschlüssige Verbindung 24 mit der ersten Metallisierung 10 des Substrats 12 verbunden sind. Ein ebener Abschnitt 32 des metallischen Kontaktierungselements 22 wird durch das dielektrische Druckelement 26, welches aus Gründen der Übersichtlichkeit in FIG 4 nur gestrichelt angedeutet ist, auf das Halbleiterelement 4 gepresst. Ein Gehäuserahmen 40 umgibt das Substrat 12 vollständig. Eine Vergussmasse, welche durch den Gehäuserahmen 40 begrenzt wird, sowie der Gehäusedeckel, welcher das metallische Kontaktierungselement 22 über das dielektrische Druckelement 26 auf den Metallformkörper 20 und somit auf den zweiten Lastkontakt 8 des Halbleiterelements 4 presst, ist aus Gründen der Übersichtlichkeit in FIG 4 nicht dargestellt. Die weitere Ausführung der Halbleiteranordnung 2 in FIG 4 entspricht der in FIG 1.

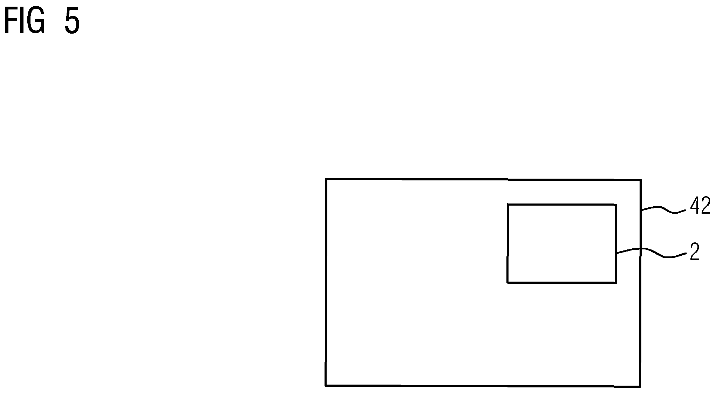

FIG 5 zeigt eine schematische Darstellung eines Stromrichters 42, welcher beispielhaft eine Halbleiteranordnung 2 umfasst.

Zusammenfassend betrifft die Erfindung ein Verfahren zur Herstellung einer Halbleiteranordnung 2 mit einem Halbleiterelement 4 und einem Substrat 12. Um eine Zuverlässigkeit der Halbleiteranordnung 2 zu verbessern, werden folgende Schritte vorgeschlagen: Stoffschlüssiges Verbinden A eines ersten Leistungskontakts 6 des Halbleiterelements 4 mit einer ersten Metallisierung 10 des Substrats 12 und eines zweiten Leistungskontakts 8 des Halbleiterelements 4, welcher auf einer dem Substrat 12 abgewandten Seite des Halbleiterelements 4 angeordnet ist, mit einem Metallformkörper 20 Kontaktieren B eines metallischen Kontaktierungselements 22 über den Metallformkörper 20 mit dem zweiten Leistungskontakt 8, Anpressen C des metallischen Kontaktierungselements 22 über ein dielektrisches Druckelement 26 an das Halbleiterelement 4, wobei über das dielektrische Druckelement 26 eine senkrecht auf das Halbleiterelement 4 wirkende Kraft F übertragen wird.

## Patentansprüche

1. Verfahren zur Herstellung einer Halbleiteranordnung (2) mit einem Halbleiterelement (4) und einem Substrat (12) umfassend folgende Schritte:
- stoffschlüssiges Verbinden (A) eines ersten Leistungskontakts (6) des Halbleiterelements (4) mit einer ersten Metallisierung (10) des Substrats (12) und
eines zweiten Leistungskontakts (8) des Halbleiterelements (4), welcher auf einer dem Substrat (12) abgewandten Seite des Halbleiterelements (4) angeordnet ist, mit einem Metallformkörper (20),
- Kontaktieren (B) eines metallischen Kontaktierungselements (22) über den Metallformkörper (20) mit dem zweiten Leistungskontakt (8),
- Anpressen (C) des metallischen Kontaktierungselements (22) über ein dielektrisches Druckelement (26) an das Halbleiterelement (4),
wobei über das dielektrische Druckelement (26) eine senkrecht auf das Halbleiterelement (4) wirkende Kraft (F) übertragen wird,
wobei das metallische Kontaktierungselement (22) unmittelbar flächig auf dem Metallformkörper (20) kontaktiert wird.

2. Verfahren nach Anspruch 1,
wobei nach dem Anpressen (C) ein Vergießen (D) der Halbleiteranordnung (4) erfolgt.

3. Verfahren nach einem der vorherigen Ansprüche,
wobei das dielektrische Druckelement (26) beim Anpressen (C) vorwiegend elastisch verformt wird.

4. Verfahren nach einem der vorherigen Ansprüche,
wobei das dielektrische Druckelement (26) über einen Gehäusedeckel (28) angepresst wird.

5. Verfahren nach einem der vorherigen Ansprüche,
wobei das metallische Kontaktierungselement (22) zur Verbindung des zweiten Leistungskontakts (8) stoffschlüssig mit der ersten Metallisierung (10) des Substrats (12) verbunden wird.

6. Verfahren nach einem der Ansprüche 1 bis 4,
wobei das metallische Kontaktierungselement (22) zur Verbindung des zweiten Leistungskontakts (8) über das dielektrische Druckelement (26) auf die erste Metallisierung (10) des Substrats (12) gepresst wird.

7. Halbleiteranordnung (2) mit einem Halbleiterelement (4) und einem Substrat (12),
wobei das Halbleiterelement (4) einen ersten Leistungskontakt (6) und einen zweiten Leistungskontakt (8) aufweist, wobei der erste Leistungskontakt (6) stoffschlüssig mit einer ersten Metallisierung (10) des Substrats (12) verbunden ist, wobei der zweite Leistungskontakt (8) auf einer dem Substrat (12) abgewandten Seite des Halbleiterelements (4) stoffschlüssig mit einem Metallformkörper (20) verbunden ist, wobei ein metallisches Kontaktierungselement (22) über den Metallformkörper (20) mit dem zweiten Leistungskontakt (8) kontaktiert ist,
wobei das metallische Kontaktierungselement (22) über ein dielektrisches Druckelement (26) an das Halbleiterelement (4) angepresst ist,
wobei über das dielektrische Druckelement (26) eine senkrecht auf das Halbleiterelement (4) wirkende Kraft (F) übertragen wird,
wobei das metallische Kontaktierungselement (22) unmittelbar flächig auf dem Metallformkörper (20) kontaktiert ist.

8. Halbleiteranordnung (2) nach Anspruch 7,
welche mittels einer Vergussmasse (34) vergossen ist.

9. Halbleiteranordnung (2) nach einem der Ansprüche 7 oder 8, wobei das dielektrische Druckelement (26) durch das Anpressen (C) vorwiegend elastisch verformt ist.

10. Halbleiteranordnung (2) nach einem der Ansprüche 7 bis 9, wobei das metallische Kontaktierungselement (22) als Blech oder als Leadframe ausgeführt ist.

11. Halbleiteranordnung (2) nach einem der Ansprüche 7 bis 10,
wobei das dielektrische Druckelement (26) über einen Gehäusedeckel (28) angepresst ist.

12. Halbleiteranordnung (2) nach einem der Ansprüche 7 bis 11,
wobei das metallische Kontaktierungselement (22) zur Verbindung des zweiten Leistungskontakts (8) stoffschlüssig mit der ersten Metallisierung (10) des Substrats (12) verbunden ist.

13. Halbleiteranordnung (2) nach einem der Ansprüche 7 bis 12,
wobei das metallische Kontaktierungselement (22) zur Verbindung des zweiten Leistungskontakts (8) über das dielektrische Druckelement (26) auf die erste Metallisierung (10) des Substrats (12) gepresst ist.

14. Stromrichter (42) mit mindestens einer Halbleiteranordnung (2) nach einem der Ansprüche 7 bis 13.

## Claims

1. Method for producing a semiconductor assembly (2) comprising a semiconductor element (4) and a substrate (12) comprising the following steps:
- materially bonding (A) a first power contact (6) of the semiconductor element (4) to a first metallisation (10) of the substrate (12) and a second power contact (8) of the semiconductor element (4), said second power contact being arranged on a face of the semiconductor element (4) facing away from the substrate (12), to a moulded metal body (20),
- contacting (B) a metallic contacting element (22) to the second power contact (8) via the moulded metal body (20),
- pressing (C) the metallic contacting element (22) against the semiconductor element (4) via a dielectric pressing element (26),
wherein a force (F) acting perpendicularly on the semiconductor element (4) is transferred via the dielectric pressing element (26),
wherein the metallic contacting element (22) is contacted directly in a planar manner on the moulded metal body (20).

2. Method according to claim 1,
wherein the semiconductor assembly (4) is encapsulated (D) after the pressing (C).

3. Method according to one of the preceding claims,
wherein the dielectric pressing element (26) is predominantly elastically deformed during the pressing (C).

4. Method according to one of the preceding claims,
wherein the dielectric pressing element (26) is pressed on via a housing cover (28).

5. Method according to one of the preceding claims,
wherein, to connect the second power contact (8), the metallic contacting element (22) is connected in a materially bonded manner to the first metallisation (10) of the substrate (12).

6. Method according to one of claims 1 to 4,
wherein, to connect the second power contact (8), the metallic contacting element (22) is pressed onto the first metallisation (10) of the substrate (12) via the dielectric pressing element (26).

7. Semiconductor assembly (2) comprising a semiconductor element (4) and a substrate (12),
wherein the semiconductor element (4) has a first power contact (6) and a second power contact (8),
wherein the first power contact (6) is connected in a materially bonded manner to a first metallisation (10) of the substrate (12),
wherein the second power contact (8) is connected in a materially bonded manner to a moulded metal body (20) on a face of the semiconductor element (4) facing away from the substrate (12),
wherein a metallic contacting element (22) is contacted to the second power contact (8) via the moulded metal body (20), wherein the metallic contacting element (22) is pressed against the semiconductor element (4) via a dielectric pressing element (26),
wherein a force (F) acting perpendicularly on the semiconductor element (4) is transferred via the dielectric pressing element (26),
wherein the metallic contacting element (22) is contacted directly in a planar manner on the moulded metal body (20).

8. Semiconductor assembly (2) according to claim 7,
which is encapsulated by means of an encapsulating compound (34).

9. Semiconductor assembly (2) according to one of claims 7 or 8,
wherein the dielectric pressing element (26) is predominantly elastically deformed by the pressing (C).

10. Semiconductor assembly (2) according to one of claims 7 to 9,
wherein the metallic contacting element (22) is embodied as a metal sheet or lead frame.

11. Semiconductor assembly (2) according to one of claims 7 to 10,
wherein the dielectric pressing element (26) is pressed on via a housing cover (28).

12. Semiconductor assembly (2) according to one of claims 7 to 11,
wherein, to connect the second power contact (8), the metallic contacting element (22) is connected in a materially bonded manner to the first metallisation (10) of the substrate (12).

13. Semiconductor assembly (2) according to one of claims 7 to 12,
wherein, to connect the second power contact (8), the metallic contacting element (22) is pressed onto the first metallisation (10) of the substrate (12) via the dielectric pressing element (26).

14. Power converter (42) comprising at least one semiconductor assembly (2) according to one of claims 7 to 13.

## Revendications

1. Procédé de fabrication d'un agencement (2) à semiconducteur comprenant un élément (4) à semiconducteur et un substrat (12) comprenant les stades suivants :
- liaison (A) à coopération de matière d'un premier contact (6) de puissance de l'élément (4) à semiconducteur à une première métallisation (10) du substrat (12) et
d'un deuxième contact (8) de puissance de l'élément (4) à semiconducteur, qui est disposé sur une face de l'élément (4) à semiconducteur, non tournée vers le substrat (12), à un corps (20) métallique moulé,
- mise en contact (B) d'un élément (22) métallique de mise en contact avec le deuxième contact (8) de puissance par l'intermédiaire du corps (20) métallique moulé,
- application (C) par pression de l'élément (22) métallique de mise en contact sur l'élément (4) à semiconducteur par un élément (26) diélectrique de pression,
dans lequel par l'élément (26) diélectrique de pression, on transmet une force (F) s'appliquant perpendiculairement à l'élément (4) à semiconducteur,
dans lequel on met l'élément (22) métallique de mise en contact directement en surface en contact avec le corps (20) métallique moulé.

2. Procédé suivant la revendication 1,
dans lequel après l'application (C) par pression, on effectue une coulée (D) de l'agencement (4) à semiconducteur.

3. Procédé suivant l'une des revendications précédentes,
dans lequel on déforme principalement élastiquement l'élément (26) diélectrique de pression, lors de l'application (C) d'une pression.

4. Procédé suivant l'une des revendications précédentes,
dans lequel on applique l'élément (26) diélectrique de pression par pression sur un couvercle (28) de boîtier.

5. Procédé suivant l'une des revendications précédentes,
dans lequel on relie, à coopération de matière avec la première métallisation (10) du substrat (12), l'élément (22) métallique de mise en contact pour la liaison du deuxième contact (8) de puissance.

6. Procédé suivant l'une des revendications 1 à 4,
dans lequel on presse l'élément (22) métallique de mise en contact pour la liaison du deuxième contact (8) de puissance sur la première métallisation (10) du substrat (12) par l'intermédiaire de l'élément (26) diélectrique de pression.

7. Agencement (2) à semiconducteur comprenant un élément (4) à semiconducteur et un substrat (12),
dans lequel l'élément (4) à semiconducteur a un premier contact (6) de puissance et un deuxième contact (8) de puissance,
dans lequel le premier contact (6) de puissance est relié à coopération de matière à une première métallisation (10) du substrat (12),
dans lequel le deuxième contact (8) de puissance est relié à un corps (20) métallique moulé à coopération de matière sur une face de l'élément (4) à semiconducteur non tournée vers le substrat (12),
dans lequel un élément (22) métallique de mise en contact est mis en contact avec le deuxième contact (8) de puissance par l'intermédiaire du corps (20) métallique moulé,
dans lequel l'élément (22) métallique de mise en contact est appliqué par pression sur l'élément (4) à semiconducteur par l'intermédiaire d'un élément (26) diélectrique de pression,
dans lequel on transmet par l'élément (26) diélectrique de pression, une force (F) s'appliquant perpendiculairement à l'élément (4) à semiconducteur,
dans lequel l'élément (22) métallique de mise en contact est mis en contact directement en surface sur le corps (20) métallique de forme.

8. Agencement (2) à semiconducteur suivant la revendication 7, qui est coulé au moyen d'une masse (34) de coulée.

9. Agencement (2) à semiconducteur suivant l'une des revendications 7 ou 8,
dans lequel l'élément (26) diélectrique de pression est déformé d'une manière prépondérante élastiquement par l'application (C) d'une pression.

10. Agencement (2) à semiconducteur suivant l'une des revendications 7 à 9,
dans lequel l'élément (22) métallique de mise en contact est réalisé sous la forme d'une tôle ou sous la forme d'une leadframe.

11. Agencement (2) à semiconducteur suivant l'une des revendications 7 à 10,
dans lequel l'élément (26) diélectrique de pression est appliqué par pression sur un couvercle (28) de boîtier.

12. Agencement (2) à semiconducteur suivant l'une des revendications 7 à 11,
dans lequel l'élément (22) métallique de mise en contact est, pour liaison du deuxième contact (8) de puissance, relié à coopération de matière à la première métallisation (10) du substrat (12).

13. Agencement (2) à semiconducteur suivant l'une des revendications 7 à 12,
dans lequel l'élément (22) métallique de mise en contact est, pour liaison du deuxième contact (8) de puissance, pressé sur la première métallisation (10) du substrat (12) par l'élément (26) diélectrique de pression.

14. Convertisseur (42) comprenant un agencement (2) à semiconducteur suivant l'une des revendications 7 à 13.
